# EUROPEAN PATENT APPLICATION

(11) **EP 4 800 447 A1**
(43) Date of publication of application: **02.09.2026**
(21) Application number: 25858414.3
(22) Date of filing: 08.05.2025
(51) Int. Cl.: G02B 6/024, G02B 6/036, G02B 6/028, C03B 37/027, C03B 37/018, C23C 16/40, C23C 16/52

(54) **PANDA-TYPE POLARIZATION-MAINTAINING OPTICAL FIBER AND PREPARATION METHOD THEREFOR**

(30) Priority: 30.08.2024 CN 202411204641
(71) Applicant: Yangtze Optical Fibre and Cable Joint Stock Limited Company, East Lake High-tech Development Zone Wuhan Hubei 430073 (CN)
(72) Inventor: HU, Xiaolong, Wuhan, Hubei 430073 (CN); LUO, Cheng, Wuhan, Hubei 430073 (CN); CHANG, Huafeng, Wuhan, Hubei 430073 (CN); TANG, Hao, Wuhan, Hubei 430073 (CN); YANG, Kun, Wuhan, Hubei 430073 (CN); WU, Qin, Wuhan, Hubei 430073 (CN); YANG, Chen, Wuhan, Hubei 430073 (CN); ZHANG, Yifei, Wuhan, Hubei 430073 (CN); LI, Chen, Wuhan, Hubei 430073 (CN); XIONG, Wei, Wuhan, Hubei 430073 (CN); WANG, Sheng, Wuhan, Hubei 430073 (CN); YANG, Mei, Wuhan, Hubei 430073 (CN); XIONG, Siyi, Wuhan, Hubei 430073 (CN); DENG, Min, Wuhan, Hubei 430073 (CN); YU, Lihua, Wuhan, Hubei 430073 (CN)
(74) Representative: Lorenz Seidler Gossel Part. mbB
(86) International application number: PCT/CN2025/093305
(87) International publication number: WO 2026/045364

(57) **Abstract**

The present disclosure relates to the technical field of optical fibers, and discloses a panda-type polarization-maintaining optical fiber and a preparation method therefor. Stress regions of the panda-type polarization-maintaining optical fiber provided in the present disclosure are distributed symmetrically on two sides of a fiber core at an interval, and are entirely cladded by an inner cladding. In combination with a design of a fluorine-doped fiber core, a design of viscosity matching, a design of the diameter of the stress region, and a gradient design of the stress region, the polishing performance and the mechanical performance of the optical fiber can be improved, so that the optical fiber has a better birefringence performance, a better wide-temperature performance, a better reliability, and a better resistance to deformation. Meanwhile, the present disclosure prepares a polarization-maintaining parent rod by using a PCVD large-sized process, in which the fiber core, the inner cladding, and the outer cladding are formed integrally, and this process can achieve entire cladding of the stress region by the inner cladding. The present disclosure can greatly simplify preparation procedures of the panda-type polarization-maintaining optical fiber, and can improve the performance of the optical fiber.

## Description

### Field of the Invention

The present disclosure relates to the technical field of optical fibers, and in particular, to a panda-type polarization-maintaining optical fiber and a preparation method therefor.

### Background of the Invention

The polarization-maintaining optical fiber is widely used in fields such as aerospace, aviation, marine navigation, industrial manufacturing, and communications. In an interferometric optical fiber sensor based on optical coherence detection, the use of the polarization-maintaining optical fiber can ensure that a linear polarization direction remains unchanged, thereby improving a coherent signal-to-noise ratio and enabling high-precision measurement of physical quantities. The polarization-maintaining optical fiber, as a special optical fiber, is mainly used in sensors such as an optical fiber gyroscope and an optical fiber hydrophone and in optical fiber communication systems such as dense wavelength division multiplexing (DWDM) and erbium-doped fiber amplifiers (EDFA), and is a special optical fiber having a wide application value.

However, the existing panda-type polarization-maintaining optical fiber mainly has the following problems: (1) the optical fiber has a relatively poor polishing performance; (2) the optical fiber has a poor wide-temperature performance; (3) the stability of the optical fiber or its resistance to deformation needs to be improved; and (4) the stress distribution inside the optical fiber is uneven. Existing preparation methods of the panda-type polarization-maintaining optical fiber mainly have the problem of complex preparation procedures or a poor practical operability.

For example, the technical solution disclosed in the patent CN104445912A includes the following steps: fabricating a core rod of an optical fiber and fabricating polarization-maintaining stress rods; symmetrically fixing two polarization-maintaining stress rods at both sides of the core rod according to needs of the stress distribution; carrying out over-cladding deposition on the core rod and the polarization-maintaining stress rods by means of an outside deposition method to obtain a preform soot; and sintering the preform soot to obtain a polarization-maintaining optical fiber preform having a circular cross section. The above method has a poor practical operability, and has an obvious defect. Two stress rods are symmetrically fixed at both sides of the core rod by a clamp for deposition, and the rods contract in the process of sintering, which causes a change of a position of the stress rods. Thus, it is very difficult to ensure symmetry in an actual operation process, which leads to non-uniform stress distribution in the optical fiber.

For example, the technical solution disclosed in the patent CN112305664A includes the following steps: first preparing a core rod by using a method of vapor-phase deposition inside a tube, and an inner cladding and an outer cladding are prepared outside the core rod by using a manner of vapor deposition on an outer surface, to obtain a polarization-maintaining parent rod. The procedures of the above method are complex, and the core rod, the inner cladding and the outer cladding are prepared with different preparation processes, which leads to a large stress difference at the interface between the core rod and the inner cladding.

For example, the technical solution disclosed in the patent CN102910812B and the technical solution disclosed in the patent CN112327405A are similar and mainly include the following steps: fabricating a polarization-maintaining core rod and two boron-doped stress rods by using a PCVD process; melting the polarization-maintaining rod by using a silica sleeve at a high temperature and drawing to obtain a polarization-maintaining parent rod; drilling holes in the polarization-maintaining parent rod; embedding the boron-doped stress rods into the holes to assemble into a polarization-maintaining optical fiber preform; and drawing the polarization-maintaining optical fiber preform into a polarization-maintaining optical fiber in a melted state. The above method is a conventional commonly-used method in China, but it has several defects. The defects are as follows. 1. After the core rod is fabricated by using the PCVD, it is required to put a sleeve over the core rod and draw the assembly so as to obtain a polarization-maintaining parent rod, preparation procedures of which are complex. 2. In the process of melting at a high temperature and drawing, an additional thermal stress is introduced, and the magnitude of an axial thermal stress varies, which leads to an uneven stress on the parent rod; and the stress affects a change of the refractive index of a material, which leads to poor consistency in optical parameters of the drawn optical fiber. 3. When the sleeve is put over the core rod, there is a gap between the core rod and an inner bore of the sleeve actually, and the absolute central position of the core rod cannot be guaranteed during the drawing process, which leads to a large geometric deviation in the concentricity between the fiber core and the cladding of the optical fiber. 4. Due to a large cross-sectional area of the sleeve and a small cross-sectional area of the core rod, the width available for depositing the inner cladding during the preparation of the core rod is limited. 5. Parameters of the polarization-maintaining parent rod obtained by means of a sleeve and by drawing are affected by parameters of the sleeve, such as the roundness and the wall deviation of the sleeve itself; and currently domestic sleeve manufacturing processes are still immature, and sleeves are imported in most cases, which leads to increased costs and poor controllability of raw materials. 6. During the drawing preparation process, it is easy to cause secondary contamination of the core rod, resulting in problems on attenuation and strength.

### Summary of the Invention

The present disclosure provides a panda-type polarization-maintaining optical fiber and a preparation method therefor to solve problems in the prior art that preparation procedures of the panda-type polarization-maintaining optical fiber are complex and the performance thereof needs to be improved.

According to a first aspect, the present disclosure provides a panda-type polarization-maintaining optical fiber, including: a fiber core, an inner cladding, stress regions, and an outer cladding; and stress regions are distributed symmetrically on two sides of the fiber core at an interval, and are entirely cladded by the inner cladding.

Preferably, a diameter D3 of the stress region satisfies D3∈[0.25D4, 0.3D4], and D4 is a diameter of the outer cladding.

Preferably, the stress region includes a flat layer and a gradient layer sequentially from inside to outside.

Preferably, a single-side thickness of the gradient layer is 0.1D3.

Preferably, a viscosity of the stress region is less than a viscosity of the fiber core, the viscosity of the fiber core is less than a viscosity of the inner cladding, and the viscosity of the inner cladding is less than a viscosity of the outer cladding.

Preferably, the inner cladding is a fluorine-doped inner cladding, and a relative refractive index Δ2 of the inner cladding satisfies Δ2∈[-0.2%, -0.1%]; and the fiber core is a fluorine- and germanium-codoped fiber core, the viscosity of the fiber core is adjusted by a fluorine doping amount, and a contribution Δ of fluorine in the fiber core to the relative refractive index satisfies Δ∈[-0.15%, -0.05%].

According to a second aspect, the present disclosure provides a preparation method for a panda-type polarization-maintaining optical fiber, including the following steps:
depositing an inner cladding layer and a core layer sequentially in a liner tube by using a PCVD large-sized process, followed by collapsing and consolidating the liner tube after deposition to form a polarization-maintaining parent rod, wherein an inner cladding of the polarization-maintaining parent rod is configured to clad the entire stress region, wherein the large-sized PCVD process employs a lathe provided with a resonant cavity having an inner bore size greater than or equal to 45 mm, and a rated power of a power supply of a high-frequency system for the PCVD is greater than or equal to 10 kW;
drilling a pair of symmetric circular holes longitudinally on two sides of a centerline of the polarization-maintaining parent rod, wherein a centerline of the circular hole is parallel to and coplanar with the centerline of the polarization-maintaining parent rod;
preparing two stress rods, and treating the stress rods by polishing and etching;
inserting the two treated stress rods respectively into the circular holes on two sides of the polarization-maintaining parent rod, to assemble a panda-type polarization-maintaining optical fiber preform; and
drawing the panda-type polarization-maintaining optical fiber preform in a melted state to obtain the panda-type polarization-maintaining optical fiber.

Preferably, when depositing the inner cladding layer, a mixed gas of silicon tetrachloride, oxygen, and hexafluoroethane is introduced into the liner tube to react to form fluorine-doped silica that deposits in the liner tube; and
when depositing the inner cladding layer, a flow rate of silicon tetrachloride is 100-1000 sccm, a flow rate of oxygen is 1000-3000 sccm, a flow rate of hexafluoroethane is 10-100 sccm, a temperature is 1000-1500°C, and the number of deposited layers is 19000-20000.

Preferably, when depositing the core layer, a mixed gas of silicon tetrachloride, germanium tetrachloride, oxygen, and hexafluoroethane is introduced into the liner tube to react to form fluorine-doped silica and germanium dioxide that deposit in the liner tube; and
when depositing the core layer, a flow rate of silicon tetrachloride is 100-1000 sccm, a flow rate of germanium tetrachloride is 2-100 sccm, a flow rate of oxygen is 300-3000 sccm, a flow rate of hexafluoroethane is 2-100 sccm, a temperature is 1000-1500°C, and the number of deposited layers is 500-4800.

Preferably, when collapsing the liner tube after deposition, a pressure in the liner tube is adjusted to a slight positive pressure or a slight negative pressure in a range from -50 mbar to +20 mbar, a temperature is adjusted to 1600-2000°C, a moving speed of a heating furnace is adjusted to 20-100 mm/min, and a collapsing amount per scan of the liner tube is controlled to be 1-5 mm; and when consolidating, the pressure in the liner tube is adjusted to a slight negative pressure in a range from -950 mbar to 0 mbar, the temperature is adjusted to 1800-2200°C, and the moving speed of the heating furnace is adjusted to 10-40 mm/min.

One or more technical solutions provided in the present disclosure have at least the following technical effects or advantages.

In terms of optical fiber designs, an inner cladding of an existing conventional panda-type polarization-maintaining optical fiber has a relatively small width, so that the inner cladding can only clad an inner edge of the stress region and cannot clad the entire stress region. However, the inner cladding of the present disclosure is extremely wide and can clad the entire stress region, and the stress region includes a flat layer and a gradient layer (i.e., a position at an edge of the stress region adopts a gradient design) sequentially from inside to outside, so that a viscosity difference at the interface position between an outer edge of the stress region and the inner cladding layer can be reduced, which reduces the circumstance that the edge of the stress region of the optical fiber is easy to fracture during polishing and enhances the polishability of the optical fiber.

In addition, when the polarization-maintaining optical fiber is applied in the field of gyroscopes, a wide-temperature performance of optical fiber is a critical factor limiting the accuracy of the gyroscopes. A poor wide-temperature performance of polarization-maintaining optical fiber is mainly because material expansion causes a compressive stress or a tensile stress on the fiber core. The polarization-maintaining optical fiber provided in the present disclosure includes an extremely wide fluorine-doped inner cladding. Since an expansion coefficient of SiO₂ is 0.5×10⁻⁶/°C and an expansion coefficient of fluorine-doped glass is about 0.3×10⁻⁶/°C, the present disclosure can increase a diameter of the fluorine-doped inner cladding to increase an effective area of the fluorine-doped inner cladding so as to reduce an expansion coefficient of a cladding of the optical fiber, thereby reducing the tensile stress or the compressive stress on the fiber core due to temperature variations and material expansion and improving the wide-temperature performance of optical fiber. Meanwhile, fluorine-doped silica glass exhibits a superior performance compared to pure silica glass in terms of strength and elastic modulus, and enhanced strength and elastic modulus means that the fluorine-doped silica glass can maintain a better shape stability under an external force and has a greater resistance to deformation.

The stress region of the conventional polarization-maintaining optical fiber is made of a borosilicate glass, and has a low viscosity; and the cladding is made of a pure silica glass, and has a high viscosity, so that there is a great viscosity difference at the interface position of the stress region, which leads to a great stress at the interface position of the stress region. When the optical fiber is subjected to an external stress, such as polishing of the optical fiber, the interface position of the stress region is easy to fracture, which affects the reliability of the optical fiber. The present disclosure performs an optimized design for viscosity matching of the optical fiber. By designing a fluorine-doped extremely-wide inner cladding to clad the entire stress region, the viscosity of the outer cladding at the boundary of the stress region is reduced, and thus a viscosity difference between an inner side and an outer side at the boundary of the stress region is reduced, thereby optimizing a stress at the interface of the stress region of the optical fiber and improving the reliability of the optical fiber.

Meanwhile, using the extremely-wide fluorine-doped inner cladding can effectively increase an area ratio of the highly fluorine-doped inner cladding to the entire cladding portion, and can reduce the overall viscosity of the optical fiber. The reduction of the overall viscosity of the optical fiber means that drawing can be carried out at a lower furnace temperature, thereby reducing attenuation changes of the optical fiber caused by diffusion of boron elements in the stress region at high temperatures and effectively improving the uniformity of attenuation.

In terms of the preparation of the optical fiber, the present disclosure first prepares a polarization-maintaining parent rod by using a PCVD large-sized process (for example, the PCVD-R47 process) by means of a lathe with a resonant cavity having an inner bore size greater than or equal to 45 mm and a high-frequency system having a rated power of a power supply greater than or equal to 10 kW, and the obtained polarization-maintaining parent rod has an extremely-wide fluorine-doped inner cladding which can clad the entire stress region; two stress rods are prepared; then a pair of circular holes are drilled in the polarization-maintaining parent rod, and after that two stress rods treated by polishing and etching are respectively inserted into the circular holes on two sides of the polarization-maintaining parent rod, to assemble a panda-type polarization-maintaining optical fiber preform; and finally the panda-type polarization-maintaining optical fiber preform is drawn in a melted state to obtain the panda-type polarization-maintaining optical fiber. Taking the use of the PCVD-R47 as an example, the present disclosure can make full use of advantages of the PCVD-R47 process. Based on the dimensional characteristics of an inner bore of the resonant cavity used in the PCVD-R47, the fiber core (which corresponds to a core layer in the panda-type polarization-maintaining optical fiber preform), the inner cladding, and the outer cladding (which corresponds to a sleeve in the panda-type polarization-maintaining optical fiber preform) in the panda-type polarization-maintaining optical fiber prepared in the present disclosure are formed integrally. Compared with an existing conventional preparation method for a panda-type polarization-maintaining optical fiber which prepares a polarization-maintaining parent rod by procedures of putting a sleeve over the core rod and drawing, the present disclosure can greatly simplify the preparation procedures of the polarization-maintaining parent rod, so as to greatly simplify the preparation procedures of the panda-type polarization-maintaining optical fiber. Besides, since the procedures of putting a sleeve over the core rod and drawing are not needed in the present disclosure, the problem of centering of the core rod when putting a sleeve over the core rod can be avoided, so as to evade a larger concentricity between the fiber core and the cladding of the optical fiber from the source, meanwhile evade the problem of a higher attenuation of the optical fiber caused by the introduction of impurities in the drawing process, and evade the problem of secondary contamination of the core rod caused by drawing in the preparation process. Since the present disclosure does not involve the high-temperature melting and drawing process, no additional thermal stress is introduced, which can ensure the uniformity of the stress on the parent rod and improve the consistency of optical parameters of the optical fiber. The present disclosure uses the PCVD-R47 process, so that the deposition efficiency of the inner cladding layer and the deposition efficiency of the core layer can reach 100%, and a profile of the core rod can be precisely controlled to ensure that the profile of the core rod is consistent with the calculated theoretical value and improve the optical performance of the optical fiber. Compared with the conventional preparation methods, the present disclosure uses the PCVD-R47 process, so that an area ratio before and after collapsing is larger, which is more beneficial to the control of the out-of-roundness of the core layer and the out-of-roundness of the inner cladding layer. The out-of-roundness of the drawn optical fiber core and the out-of-roundness of the inner cladding layer can both be less than 0.5%. Compared with the sleeve drawing method, the present disclosure can prevent the geometric parameters of the polarization-maintaining parent rod from being affected by the parameters of the sleeve (including the roundness and wall deviation of the sleeve itself).

In addition, the present disclosure uses the PCVD-R47 process to prepare the polarization-maintaining parent rod, so as to obtain an extremely wide inner cladding and ensure that the entire stress region is cladded in the inner cladding. In combination with a design of the diameter of the stress region, a gradient design of a position at an edge of the stress region, and a design of a fluorine-doped fiber core and a design of viscosity matching of the optical fiber, relative performances of the panda-type polarization-maintaining optical fiber can be improved. The present disclosure can improve the polishing performance and the mechanical performance of the optical fiber, allow the optical fiber to have a better birefringence performance, a better wide-temperature performance, a better reliability, and a better resistance to deformation, can avoid or improve an uneven internal stress distribution of the optical fiber due to a large viscosity difference, and can effectively improve an axial consistency.

### Brief Description of the Drawings

Fig. 1 is a diagram of a radial structure of a panda-type polarization-maintaining optical fiber provided in Embodiment One of the present disclosure.
Fig. 2 is a diagram of a refractive index profile of the panda-type polarization-maintaining optical fiber provided in Embodiment One of the present disclosure.
Fig. 3 is a correlation diagram of a diameter of a stress region with a birefringence coefficient and a tensile breaking force of the panda-type polarization-maintaining optical fiber provided in Embodiment One of the present disclosure.
Fig. 4 is a correlation diagram of a diameter of a gradient layer of a stress region with a birefringence coefficient and a polishing performance of the panda-type polarization-maintaining optical fiber provided in Embodiment One of the present disclosure.
Fig. 5 is a flow diagram of procedures of a preparation method for the panda-type polarization-maintaining optical fiber provided in Embodiment Two of the present disclosure.

Reference numerals: 1-fiber core; 2-inner cladding; 3-stress region; 4-outer cladding; 5-inner coating layer; 6-outer coating layer.

### Detailed Description of the Embodiments

In order to better understand the above technical solutions, the above technical solutions are described in detail below in conjunction with the accompanying drawings and specific implementation manners.

### Embodiment One

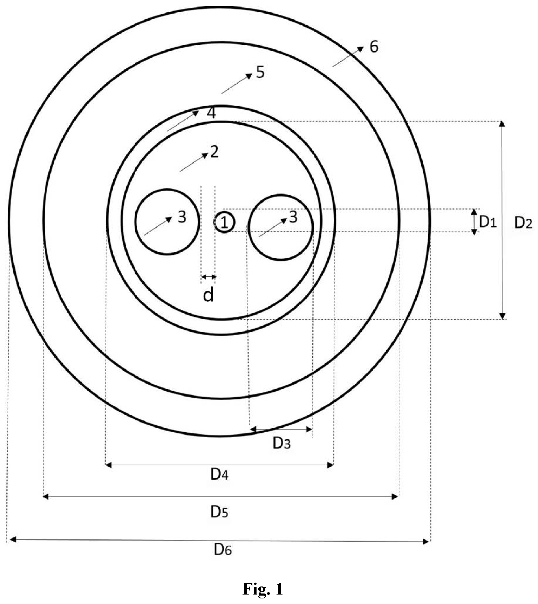

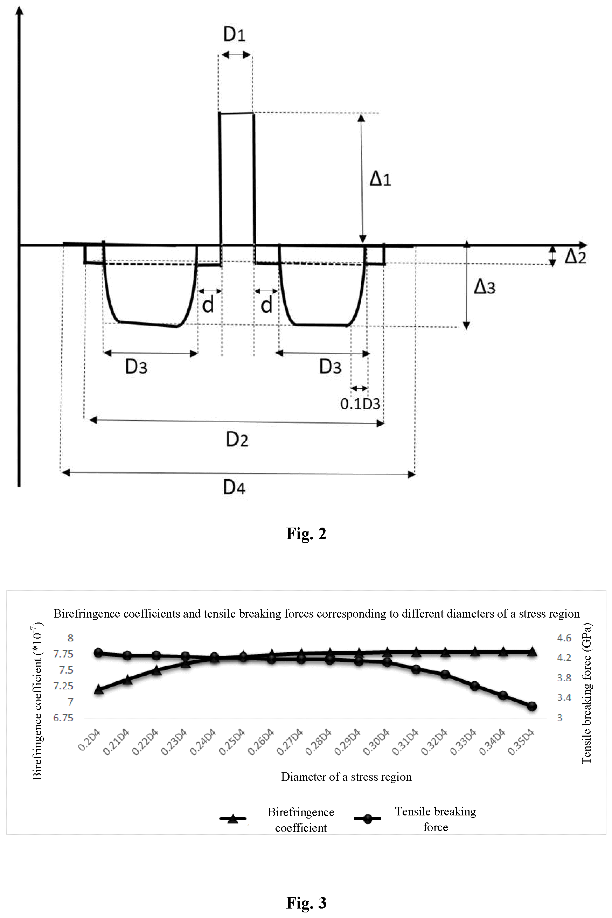

Embodiment One provides a panda-type polarization-maintaining optical fiber. Referring to Fig. 1 and Fig. 2, the panda-type polarization-maintaining optical fiber mainly includes a fiber core 1, and inner cladding 2, a stress region 3, and an outer cladding 4, and an inner coating layer 5 and an outer coating layer 6 may be further coated outside the outer cladding 4. The fiber core 1 is located in the center of the inner cladding 2, stress regions 3 are symmetrically distributed at an interval on two sides of the fiber core 1 and are entirely cladded by the inner cladding 2; and the stress region 3 includes a flat layer and a gradient layer from inside to outside.

A diameter D1 of the fiber core 1 satisfies D1∈[5.5, 7] um, a diameter D4 of the outer cladding 4 satisfies D4∈[40, 125] um, a distance d from an inner edge of the stress region 3 to an outer edge of the fiber core 1 satisfies d∈[1, 4] um, a diameter D3 of the stress region 3 satisfies D3∈[0.25D4, 0.3D4], and a diameter D2 of the inner cladding 2 satisfies D2∈[D1+2D3+2d, D4]. A diameter of the inner coating layer 5 is indicated as D5, and a diameter of the outer coating layer 6 is indicated as D6, which may be set as required.

Compared with the diameter of the outer cladding 4, it is necessary to control the diameter of the stress region 3 to be in a certain range. An excessively small diameter of the stress region 3 leads to insufficient birefringence performance, and an excessively large diameter of the stress region 3 leads to a poor mechanical strength of the optical fiber. Referring to Fig. 3, a birefringence coefficient increases as the diameter of the stress region increases; when the diameter of the stress region is less than 0.25D4, the birefringence coefficient increases rapidly as the diameter of the stress region increases, and when the diameter of the stress region is greater than 0.25D4, the birefringence coefficient tends to flatten as the diameter of the stress region increases. A tensile breaking force of the optical fiber decreases as the diameter of the stress region increases, and when the diameter of the stress region is less than 0.3D4, the tensile breaking force slowly decreases as the diameter of the stress region increases; and when the diameter of the stress region is greater than 0.3D4, the tensile breaking force rapidly decreases as the diameter of the stress region increases. Therefore, taking both the birefringence performance and the mechanical strength of the optical fiber into account, when the diameter D3 of the stress region 3 is in the range of [0.25D4, 0.3D4], both the birefringence performance and the mechanical strength of the optical fiber can reach an ideal value. The birefringence can reach above 7.72×10⁻⁴, and the tensile breaking force of the optical fiber can reach above 4.12 GPa.

Referring to Fig. 1 and Fig. 2, the inner cladding 2 is a fluorine-doped inner cladding, and a relative refractive index Δ2 of the inner cladding 2 satisfies Δ2∈ [-0.2%, -0.1%], and a corresponding viscosity of the inner cladding is 5.8-6.1 Pas at 1950°C.

The fiber core 1 in the present disclosure adopts a design of viscosity matching, and a viscosity of the fiber core 1 needs to be lower than the viscosity of the inner cladding. According to an optical waveguide design, a relative refractive index Δ1 of the fiber core 1 satisfies Δ1∈[0.55%, 0.75%]. A conventional optical fiber adopts a pure germanium-doped design, and has a viscosity of 6.1-6.25 Pas at 1950°C, and the viscosity of the fiber core is higher than the viscosity of the inner cladding. The fiber core 1 in the present disclosure adopts a fluorine- and germanium-codoped design, and the fiber core is doped with germanium and meanwhile is doped with a certain amount of fluorine to adjust the viscosity of the fiber core. When fluorine-doping Δ of the fiber core satisfies Δ∈[-0.15%, -0.05%] and corresponding germanium doping Δ satisfies Δ∈[0.6%, 0.9%], the viscosity of the fiber core 1 is 5.6-5.75 Pas at 1950°C, which enables the viscosity of the fiber core to be lower than the viscosity of the inner cladding. The fiber core Δ1 = germanium doping Δ + fluorine-doping Δ.

The stress region 3 is a boron-doped stress region, and boron-doping in the stress region directly affects the birefringence performance of the optical fiber, and a molar content of less than 15% leads to insufficient birefringence performance of the optical fiber, and weak polarization capability of the optical fiber; and a molar content of greater than 25% leads to a large stress inside the optical fiber and a poor mechanical performance of the optical fiber. In the present disclosure, a molar content of B₂O₃ in the stress region 3 ranges in [15%, 25%], and the corresponding viscosity at 1950°C is 4.7-5.2 Pas. Fracturing in the stress region when the optical fiber is polished is mainly due to a large stress at the boundary of the stress region, and thus the stress region 3 adopts a special design. The stress region 3 includes a flat layer and a gradient layer from inside to outside, and using a gradient layer design at an edge of the stress region can effectively reduce the stress at an edge position of the stress region.

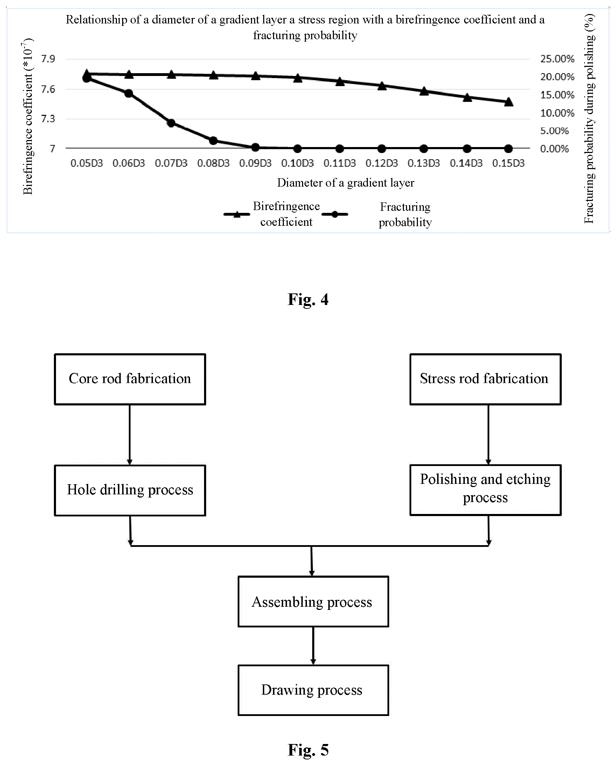

Referring to Fig. 4, a single-side thickness of the gradient layer of the stress region affects a fracturing probability when the optical fiber is polished and meanwhile affects the birefringence performance of the optical fiber. When the single-side thickness of the gradient layer is less than 0.1D3, the birefringence coefficient of the optical fiber slowly decreases as the single-side thickness of the gradient layer increases; and when the single-side thickness of the gradient layer is greater than 0.1D3, the birefringence coefficient of the optical fiber rapidly decreases as the single-side thickness of the gradient layer increases. The fracturing probability when the optical fiber is polished rapidly decreases as the single-side thickness of the gradient layer increases, and the fracturing probability when the optical fiber is polished is 0% when the single-side thickness of the gradient layer is greater than 0.1D3. Thus, the single-side thickness of the gradient layer is controlled at 0.1D3 as an ideal value, which can ensure that the birefringence coefficient of the optical fiber reaches 7.72×10⁻⁴ and at the same time the fracturing probability when the optical fiber is polished is 0%.

The outer cladding 4 has a relative refractive index Δ4 of 0% and a corresponding viscosity of 6.35 Pas at 1950°C.

By controlling the above viscosity matching of the fiber core, the diameter of the inner cladding, the diameter of the stress region, and the single-side thickness of the gradient layer of the stress region, it can be ensured that the birefringence performance of the optical fiber reaches 7.72×10⁻⁴, the tensile breaking force of the optical fiber can reach 4.12 GPa, and the fracturing probability when the optical fiber is polished is 0%.

### Embodiment Two

The present disclosure determines a size of the inner cladding based on the geometric design of the optical fiber as recited in Embodiment One and further determines the number of the deposition layers, so as to ensure that a radius of the inner cladding is greater than a distance from the outer edge of the stress region to the fiber core, so that the stress region is entirely cladded by the inner cladding.

Embodiment Two provides a preparation method for the panda-type polarization-maintaining optical fiber as recited in Embodiment One. Referring to Fig. 5, the preparation method for the panda-type polarization-maintaining optical fiber mainly includes the following steps.

### (1) Fabrication of a Core Rod and Fabrication of a Stress Rod.

An inner cladding layer and a core layer are deposited sequentially in a liner tube by using a PCVD large-sized process, followed by collapsing and consolidating the liner tube after deposition to obtain a polarization-maintaining parent rod, wherein the inner cladding of the polarization-maintaining parent rod is configured to clad the entire stress region.

The large-sized PCVD process employs a lathe provided with a resonant cavity having an inner bore size greater than or equal to 45 mm, and a rated power of a power supply of a high-frequency system for the PCVD is greater than or equal to 10 kW.

For example, the polarization-maintaining parent rod (i.e., the core rod) may be prepared by using a PCVD-R47 process, and two stress rods may be prepared by using the PCVD-R47 process or a PCVD-R31.

A fabrication sequence of the core rod and the stress rods is not limited in the present disclosure. The core rod and the stress rods may be fabricated at the same time, or a preparation sequence may be adjusted according to preparation conditions.

When depositing the inner cladding, a mixed gas of silicon tetrachloride, oxygen, and hexafluoroethane is introduced into the liner tube to react to form fluorine-doped silica that deposits in the liner tube. A flow rate of silicon tetrachloride is 100-1000 sccm, a flow rate of oxygen is 1000-3000 sccm, a flow rate of hexafluoroethane is 10-100 sccm, a temperature is 1000-1500°C, and the number of deposited layers is 19000-20000.

When depositing the core layer, a mixed gas of silicon tetrachloride, germanium tetrachloride, oxygen, and hexafluoroethane is introduced into the liner tube to react to form fluorine-doped silica and germanium dioxide that deposit in the liner tube. A flow rate of silicon tetrachloride is 100-1000 sccm, a flow rate of germanium tetrachloride is 2-100 sccm, a flow rate of oxygen is 300-3000 sccm, a flow rate of hexafluoroethane is 2-100 sccm, a temperature is 1000-1500°C, and the number of deposited layers is 500-4800.

When collapsing the liner tube after deposition, a pressure in the liner tube is adjusted to a slight positive pressure or a slight negative pressure in a range from -50 mbar to +20 mbar, a temperature is adjusted to 1600-2000°C, a moving speed of a heating furnace is adjusted to 20-100 mm/min, and a collapsing amount (i.e., an amount of variation in the diameter of the core rod) per scan of the liner tube is controlled to be 1-5 mm.

When consolidating the collapsed core rod, the pressure in the liner tube is adjusted to a slight negative pressure in a range from -950 mbar to 0 mbar, the temperature is adjusted to 1800-2200°C, and the moving speed of the heating furnace is adjusted to 10-40 mm/min.

The polarization-maintaining parent rod obtained by consolidating has an outer diameter of 40-45 mm, a diameter of an inner cladding is 30-40 mm, and a diameter of the core layer is 1.9-4.5 mm.

In addition, before depositing the inner cladding in the liner tube, the preparation method may further include: feeding a mixed gas of hexafluoroethane and oxygen into the liner tube to polish the liner tube.

In addition, after obtaining the polarization-maintaining parent rod and before drilling the circular holes, the preparation method may further include: annealing the polarization-maintaining parent rod to eliminate residual stresses.

### (2) Polishing and Etching of the Stress Rod

Specifically, after the stress rod is prepared, it is necessary to polish and etch the stress rod.

It is a scaled-down process from a rod to a fiber. A dimension of a polished stress rod directly determines a size of the stress region in the drawn optical fiber. The polished stress rod has an outer diameter of 13.5-19.6 mm. The outer diameter of the gradient layer of the optical fiber is equal to the outer diameter of the polished stress rod, and the diameter of the flat layer of the optical fiber is 12.15-17.64 mm.

Hydrofluoric acid is used to etch the polished stress rod so as to remove impurities introduced during the mechanical process of polishing the stress rod, and the etching time is controlled within 20-40 min.

### (3) Drilling Holes in the Core Rod.

Specifically, a pair of symmetric circular holes is drilled longitudinally on two sides of a centerline of the polarization-maintaining parent rod, and a centerline of the circular hole is parallel to and coplanar with the centerline of the polarization-maintaining parent rod.

The present disclosure determines the diameter of the stress rod and the distance from the edge of the stress region to the fiber core based on the geometric design of the optical fiber recited in Embodiment One, and further determines the positions for drilling the circular holes. By controlling a deviation degree of the two circular holes, the symmetry of the stress region can be guaranteed, thereby ensuring the uniformity of the stress distribution on the optical fiber.

It is a scaled-down process from a rod to a fiber. A central position of the drilled hole determines a geometric position of the stress region of the optical fiber, and a distance from a center of the hole to a center of the polarization-maintaining parent rod is 11.0-12.1 mm. In addition, a size of a bore diameter needs to be controlled within a certain range compared to an outer diameter of the polished stress rod, which can ensure that a geometric deviation degree of the stress region of the optical fiber is controlled to be within 1 um and ensure a geometric symmetry of the stress region of the optical fiber. A single-side gap needs to be controlled within 0.2 mm. That is, the size of the bore diameter needs to be controlled within 0-0.4 mm compared to the outer diameter of the polished stress rod.

It should be noted that, a processing sequence of (2) polishing and etching of the stress rod and (3) drilling holes in the core rod is not limited in the present disclosure. Step (2) and step (3) may be performed at the same time, or the preparation sequence may be adjusted according to preparation conditions. The above sequence is only exemplary. It is acceptable as long as the two steps are performed after fabricating the core rod and the stress rod and before assembling.

### (4) Assembling.

Two treated stress rods are inserted respectively into the circular holes on two sides of the polarization-maintaining parent rod, to assemble a panda-type polarization-maintaining optical fiber preform.

### (5) Drawing.

The panda-type polarization-maintaining optical fiber preform is drawn in a melted state to obtain the panda-type polarization-maintaining optical fiber.

In addition, the present disclosure further includes the following step.

### (6) Coating.

The inner coating layer and the outer coating layer are coated outside the outer cladding of the panda-type polarization-maintaining optical fiber.

In the present disclosure, the fiber core, the inner cladding, and the outer cladding are formed integrally to directly obtain a polarization-maintaining parent rod and further obtain an extremely wide fluorine-doped inner cladding to entirely clad the stress region, which may be realized specifically by an R47 large-sized process (i.e., the PCVD-R47 process) of plasma chemical vapor deposition (PCVD).

An inner bore of a resonant cavity used in the PCVD-R47 is 47 mm, an outer diameter of the rod after deposition and sintering may reach 45 mm, and an extreme diameter of the inner cladding may reach 40 mm, and the inner cladding may entirely clad the stress region. However, an inner bore of a conventional PCVD-R31 resonant cavity is 31 mm, an outer diameter of the rod after deposition and sintering may only reach 25 mm, and an extreme diameter of the inner cladding is only 21 mm. The inner cladding layer and the stress region only overlap, and the inner cladding cannot entirely clad the stress region.

A rated power of a power supply of a high-frequency system for the PCVD-R47 is 10 kW. During deposition of the inner cladding layer and the fiber core, gases such as silicon tetrachloride, germanium tetrachloride, oxygen, and hexafluoroethane may react fully, and the reaction efficiency may reach 100%. A profile of the fiber core may be controlled more precisely, so that the profile of the fiber core is consistent with the designed theoretical value. However, a rated power of a power supply of a conventional high-frequency system for the PCVD-R31 is 6 kW. During deposition, it is difficult for the reaction efficiency of gases to reach 100%. There is a difference between the profile of the fiber core and the designed theoretical value, which affects the optical performance.

The present disclosure may make full use of the following advantages of the PCVD-R47 process:
(1) The outer diameter of the deposited and sintered core rod may reach 45 mm to directly obtain the needed polarization-maintaining parent rod, and it is not necessary to put a sleeve over the core and perform drawing compared with the conventional PCVD-R31 process, so that it is easy to control the process and the production efficiency of the optical fiber is higher.
(2). It is not necessary to put a sleeve over the core and perform drawing, so that the problem of centering of the core rod when putting a sleeve over the core rod can be avoided, so as to evade the problem of a larger concentricity between the fiber core and the cladding of the optical fiber from the source, meanwhile evade the problem of a higher attenuation of the optical fiber caused by the introduction of impurities in the drawing process.
(3). The diameter of the deposited and sintered inner cladding may reach 40 mm, which meets the design requirements of the optical fiber, wherein the inner cladding is configured to clad the entire stress region, which improves the wide-temperature performance and the polishing performance of optical fiber.
(4). The deposition efficiency of the inner cladding and the deposition efficiency of the fiber layer may reach 100%, and the profile of the core rod can be controlled precisely to ensure that the profile of the core rod is consistent with the calculated theoretical value and improve the optical performance of the optical fiber.
(5). A diameter of the rod before collapsing and sintering and a diameter of the rod after collapsing and sintering in the conventional PCVD-R31 are respectively 31 mm and 25 mm, a ratio of an area before collapsing to an area after collapsing is 65%; while a diameter of the rod before collapsing and sintering and a diameter of the rod after collapsing and sintering in the PCVD-R47 are respectively 47 mm and 40-45 mm, and a ratio of an area before collapsing to an area after collapsing is 72.4%-91.6%, which is larger and is beneficial to the control of the out-of-roundness of the core layer and the out-of-roundness of the inner cladding layer (the out-of-roundness of the core layer is less than 1%, and the out-of-roundness of the inner cladding layer is less than 0.5%), so that the out-of-roundness of the fiber core of the optical fiber and the out-of-roundness of the inner cladding layer are better.

The preparation process and the process control of the present disclosure are simple, which can improve the production efficiency and the product quality.

Finally, it should be noted that the above specific embodiments are merely provided for illustrating, rather than limiting, the technical solutions of the present invention. Although the present disclosure has been described in detail with reference to examples, it would be appreciated by those of ordinary skill in the art that various modifications or equivalent substitutions may be made to the technical solutions of the present disclosure without departing from the spirit and scope of the present disclosure, and all such modifications and equivalent substitutions shall fall within the scope of the claims of the present disclosure.

## Claims

1. A panda-type polarization-maintaining optical fiber, **characterized in that** it comprises: a fiber core, an inner cladding, stress regions, and an outer cladding; and the stress regions are distributed symmetrically on two sides of the fiber core at an interval, and are entirely cladded by the inner cladding.

2. The panda-type polarization-maintaining optical fiber according to claim 1, **characterized in that** a diameter D3 of the stress region satisfies D3∈[0.25D4, 0.3D4], and D4 is a diameter of the outer cladding.

3. The panda-type polarization-maintaining optical fiber according to claim 1, **characterized in that** the stress region comprises a flat layer and a gradient layer sequentially from inside to outside.

4. The panda-type polarization-maintaining optical fiber according to claim 3, **characterized in that** a single-side thickness of the gradient layer is 0.1D3.

5. The panda-type polarization-maintaining optical fiber according to claim 1, **characterized in that** a viscosity of the stress region is less than a viscosity of the fiber core, the viscosity of the fiber core is less than a viscosity of the inner cladding, and the viscosity of the inner cladding is less than a viscosity of the outer cladding.

6. The panda-type polarization-maintaining optical fiber according to claim 1, **characterized in that** the inner cladding is a fluorine-doped inner cladding, and a relative refractive index Δ2 of the inner cladding satisfies Δ2∈[-0.2%, -0.1%]; and the fiber core is a fluorine- and germanium-codoped fiber core, the viscosity of the fiber core is adjusted by a fluorine doping amount, and a contribution Δ of fluorine in the fiber core to the relative refractive index satisfies Δ∈[-0.15%, -0.05%].

7. A preparation method for the panda-type polarization-maintaining optical fiber according to any one of claims 1 to 6, **characterized by** comprising the following steps:
depositing an inner cladding layer and a core layer sequentially in a liner tube by using a PCVD large-sized process, followed by collapsing and consolidating the liner tube after deposition to form a polarization-maintaining parent rod, wherein an inner cladding of the polarization-maintaining parent rod is configured to clad the entire stress region; wherein the large-sized PCVD process employs a lathe provided with a resonant cavity having an inner bore size greater than or equal to 45 mm, and a rated power of a power supply of a high-frequency system for the PCVD is greater than or equal to 10 kW;
drilling a pair of symmetric circular holes longitudinally on two sides of a centerline of the polarization-maintaining parent rod, wherein a centerline of the circular hole is parallel to and coplanar with the centerline of the polarization-maintaining parent rod;
preparing two stress rods, and treating the stress rods by polishing and etching;
inserting the two treated stress rods respectively into the circular holes on two sides of the polarization-maintaining parent rod, to assemble a panda-type polarization-maintaining optical fiber preform; and
drawing the panda-type polarization-maintaining optical fiber preform in a melted state to obtain the panda-type polarization-maintaining optical fiber.

8. The preparation method for the panda-type polarization-maintaining optical fiber according to claim 7, **characterized in that** when depositing the inner cladding layer, a mixed gas of silicon tetrachloride, oxygen, and hexafluoroethane is introduced into the liner tube to react to form fluorine-doped silica that deposits in the liner tube; and
when depositing the inner cladding layer, a flow rate of silicon tetrachloride is 100-1000 sccm, a flow rate of oxygen is 1000-3000 sccm, a flow rate of hexafluoroethane is 10-100 sccm, a temperature is 1000-1500°C, and the number of deposited layers is 19000-20000.

9. The preparation method for the panda-type polarization-maintaining optical fiber according to claim 7, **characterized in that** when depositing the core layer, a mixed gas of silicon tetrachloride, germanium tetrachloride, oxygen, and hexafluoroethane is introduced into the liner tube to react to form fluorine-doped silica and germanium dioxide that deposit in the liner tube; and
when depositing the core layer, a flow rate of silicon tetrachloride is 100-1000 sccm, a flow rate of germanium tetrachloride is 2-100 sccm, a flow rate of oxygen is 300-3000 sccm, a flow rate of hexafluoroethane is 2-100 sccm, a temperature is 1000-1500°C, and the number of deposited layers is 500-4800.

10. The preparation method for the panda-type polarization-maintaining optical fiber according to claim 7, **characterized in that** when collapsing the liner tube after deposition, a pressure in the liner tube is adjusted to a slight positive pressure or a slight negative pressure in a range from -50 mbar to +20 mbar, a temperature is adjusted to 1600-2000°C, a moving speed of a heating furnace is adjusted to 20-100 mm/min, and a collapsing amount per scan of the liner tube is controlled to be 1-5 mm; and when consolidating, the pressure in the liner tube is adjusted to a slight negative pressure in a range from -950 mbar to 0 mbar, the temperature is adjusted to 1800-2200°C, and the moving speed of the heating furnace is adjusted to 10-40 mm/min.
